# EUROPÄISCHE PATENTANMELDUNG

(11) **EP 2 257 142 A1**
(43) Veröffentlichungstag der Anmeldung: **01.12.2010**
(21) Anmeldenummer: 10003119.4
(22) Anmeldetag: 24.03.2010
(51) Int. Cl.: H05K 3/32, H01C 1/14, H01G 4/228, H01L 21/60

(54) **Befestigung eines Bauelementes an einem Substrat und/oder eines Anschlusselementes an dem Bauelement oder an dem Substrat durch Drucksinterung**

(30) Priorität: 26.05.2009 DE 102009022660
(71) Anmelder: Semikron Elektronik GmbH & Co. KG Patentabteilung, 90431 Nürnberg (DE)
(72) Erfinder: Sagebaum, Ulrich, 90408 Nürnberg (DE); Radüge, Christian, 90513 Zirndorf (DE)

(57) **Zusammenfassung**

Es wird eine Befestigung mindestens eines Bauelementes (12) an einem Substrat (10) und/oder eines Anschlusselementes (14) an dem Bauelement (12) und/oder an dem Substrat (10) durch Drucksintern beschrieben. Zwischen dem Bauelement (12) und dem Substrat (10) und/oder dem Anschlusselement (14) und dem Bauelement (12) und/oder dem Anschlusselement (14) und dem Substrat (10) ist eine die unterschiedlichen Wärmeausdehnungskoeffizienten des Anschlusselementes (14), des Bauelementes (12) und des Substrates (10) ausgleichende Zwischenschicht (16) vorgesehen, die eine Dicke von ≥ 50 µm aufweist. Die Sinter-Zwischenschicht (16) besteht aus Silber oder einer Silberlegierung und ist nicht vollflächig sondern oberflächlich strukturiert ausgebildet.

## Beschreibung

Die Erfindung betrifft eine Befestigung mindestens eines Bauelementes an einem Substrat und/oder eines Anschlusselementes an dem Bauelement und/oder an dem Substrat durch Drucksinterung, wobei zwischen dem Bauelement und dem Substrat und/oder dem Anschlusselement und dem Bauelement und/oder dem Anschlusselement und dem Substrat eine unterschiedliche Wärmeausdehnungskoeffizienten des Anschlusselementes, des Bauelementes und des Substrates ausgleichende Zwischenschicht vorgesehen ist.

Aus der DE 3414065 C2 ist eine Befestigung eines Bauelementes an einem Substrat und ein Verfahren zur Herstellung der Befestigung bekannt. Bei dieser bekannten Befestigung ist eine metallische Kontaktierungsschicht des Bauelementes durch eine Metallpulver enthaltende und unter Temperatureinwirkung gebildete Verbindungsschicht mit einer metallischen Kontaktoberfläche des Substrates elektrisch und thermisch leitend verbunden. Die Verbindungsschicht besteht ausschließlich aus durch Trockensintern verfestigtem Metallpulver, die sowohl an die Kontaktierungsschicht des Bauelementes als auch an die Kontaktoberfläche des Substrates angesintert ist. Die Verbindungsschicht dieser bekannten Befestigung weist eine Schichtdicke zwischen 10 und 100 µm auf. Die Kontaktierungsschicht des Bauelementes besteht vorzugsweise aus Silber, die auf eine Diffusionssperrschicht aus Nickel aufgebracht sein kann. Gemäß einer bevorzugten Ausgestaltung ist bei dieser bekannte Befestigung die Verbindungsschicht aus dem Pulver eines Edelmetalls oder einer Edelmetall-Legierung gebildet. Bei dem Edelmetall kann es sich um Silber handeln.

Die DE 10 2004 056 702 B3 offenbart ein Verfahren zur Befestigung von elektronischen Bauelementen auf einem Substrat, insbesondere von Leistungshalbleiterbauelementen, wie Dioden, Transistoren oder Thyristoren, auf einem Substrat und/oder zur Befestigung von Anschlusselementen auf elektronischen Bauelementen oder einem Substrat durch Drucksintern. Dabei wird eine aus einem Metallpulver und einem Lösungsmittel bestehende pastöse Schicht auf eine erste, strukturierte Trägerfolie aufgebracht. Nach dem Trocknen dieser pastösen Schicht wird auf die getrocknete Schicht eine zweite, gegenüber der ersten Trägerfolie dünne Folie aufgebracht. Der Verbund aus der ersten Folie mit der getrockneten Schicht und der zweiten Folie wird mit einem Druck beaufschlagt, wodurch die Haftkraft zwischen der getrockneten Schicht und der zweiten Folie größer wird als die Haftkraft zwischen der getrockneten Schicht und der ersten, strukturierten Trägerfolie. Nach dieser Druckbeaufschlagung wird die zweite Folie mit der daran haftenden Schicht von der ersten strukturierten Trägerfolie abgehoben. Anschließend werden einzelne Metallplättchen, die aus der getrockneten Schicht gebildet sind, auf dem jeweiligen Bauelement oder auf dem zugehörigen Substrat positioniert. Abschließend erfolgt eine Druckbeaufschlagung der Anordnung aus dem Substrat, dem Bauelement und dem Anschlusselement oder der Anordnung aus dem Substrat und dem Anschlusselement mit jeweils dazwischen angeordneten Metallplättchen zu deren jeweiliger Sinterverbindung. Auch bei diesem bekannten Verfahren kommt als Metallpulver vorzugsweise Silber oder eine Silberlegierung zur Anwendung.

Aus der DE 100 65 495 A1 ist ein Leistungshalbleitermodul bekannt, das aus einer Grundplatte, mindestens einem davon mittels eines elektrisch isolierenden Substrates getrennten ersten Anschlusselement, mindestens einem darauf befindlichen Sandwich aus einem ersten flächigen Metallkörper, einem Halbleiterbauelement sowie einem zweiten flächigen Metallkörper, mindestens einem Druckelement und mindestens einem zweiten Anschlusselement sowie einem Gehäuse besteht. Der erste und der zweite flächige Metallkörper sind von Molybdänscheiben gebildet.

Ein Leistungshalbleitermodul mit flächigen Metallkörpern, die vorzugsweise aus Molybdän bestehen, ist auch aus der DE 10 2006 034 964 B3 bekannt. Die flächigen Metallkörper aus Molybdän dienen hierbei dazu, mechanische Spannungen, die durch thermische Ausdehnung entstehen, zu kompensieren. Von Nachteil sind hierbei die Kosten für das Molybdän. Außerdem bedingen die flächigen Metallkörper aus Molybdän eine aufwändige Bearbeitung der Fügepartner, um die erforderliche hoch genaue Planarität zu realisieren. Diese aufwändige Bearbeitung erfolgt durch Schleifen, Fügen oder dergleichen. Außerdem erfolgt oftmals eine Veredelung der flächigen Metallkörper aus Molybdän. Diese Veredelung wird durch zusätzliches Aufbringen beispielsweise von Ruthenium oder von Nickel plus Silber verwirklicht.

Der Erfindung liegt die Aufgabe zugrunde, eine Befestigung der eingangs genannten Art zu schaffen, bei welcher auf das kostenintensive Molybdän verzichtet werden kann.

Diese Aufgabe wird erfindungsgemäß durch die Merkmale des Anspruches 1, d.h. dadurch gelöst, dass die Sinter-Zwischenschicht aus Silber oder einer Silberlegierung besteht und nicht vollflächig sondern oberflächlich strukturiert ausgebildet ist, und eine Dicke von ≥ 50 µm aufweist.

Durch die oberflächlich strukturierte, relativ dicke Sinter-Zwischenschicht aus Silber oder einer Silberlegierung ist es in vorteilhafter Weise möglich, durch die unterschiedlichen thermischen Ausdehnungskoeffizienten von beispielsweise Silizium, Kupfer und Aluminium entstehende mechanische Spannungen zu kompensieren, weil die besagten mechanischen Spannungen nicht vollflächig sondern nur partiell, d.h. an den vereinzelten Verbindungsstellen auftreten. Die Geometrie der Oberflächenstrukturierung ist dabei derartig gewählt, dass entstehende einzelne Spannungsspitzen nicht zu einem Bruch des Bauelementes führen und die Stromtragfähigkeit für das Bauelement erhalten bleibt. Bei dem Bauelement handelt es sich üblicherweise um ein Chipbauelement.

Ein weiterer Vorteil der erfindungsgemäßen Befestigung besteht darin, dass keine hoch genaue Planarität erforderlich ist, sondern die Oberflächenrauheit der Fügepartner, d.h. des Anschlusselementes, des Bauelementes und des Substrates, vernachlässigt werden kann. Eine Oberflächenrauheit von beispielsweise 10 bis 15 µm ist problemlos tolerierbar.

Bei der erfindungsgemäßen Befestigung kann die Sinter-Zwischenschicht mit die Oberflächenstrukturierung bildenden Durchgangslöchern ausgebildet sein. Eine andere Möglichkeit besteht darin, dass die Sinter-Zwischenschicht mindestens einseitig mit die Oberflächenstrukturierung bildenden Sacklöchern ausgebildet ist. Dabei können die die Oberflächenstrukturierung bildenden Sacklöcher an der einen und/oder an der gegenüberliegenden anderen Seite der Sinter-Zwischenschicht ausgebildet sein. Bei dieser einer oder gegenüberliegenden anderen Seite der Sinter-Zwischenschicht kann es sich um die einem Anschlusselement, dem Bauelement oder dem Substrat zugewandte Seite der Sinter-Zwischenschicht handeln.

Bei der Sinter-Zwischenschicht handelt es sich vorzugsweise um ein mehrschichtiges Gebilde, das durch mehrfaches Sprühen, Siebdrucken, Schablonendrucken o. dgl. eines geeigneten Pastenmaterials hergestellt wird.

Mit Hilfe der mehrschichtigen Sinter-Zwischenschicht einer Wanddicke von ≥ 50 µm ist es in vorteilhafter Weise möglich, die infolge der unterschiedlichen thermischen Ausdehnungskoeffizienten beispielsweise von Silizium (3-4x10⁻⁶ K⁻¹), Kupfer (16,5 x10⁻⁶ K⁻¹) und Aluminium (23 x10⁻⁶ K⁻¹) entstehenden mechanischen Spannungen einfach und preisgünstig zu kompensieren. Zur weiteren Reduktion von durch unterschiedliche thermische Ausdehnungskoeffizienten bedingten mechanischen Spannungen kann es vorteilhaft sein, wenn auf jedem Fügepartner wie einem Bauelement und/oder einem Substrat und/oder einem Anschlusselement eine Zinkat-Oberflächenschicht vorgesehen ist. Mit Hilfe der Zinkat-Oberflächenschicht ist beispielsweise auf Aluminium eine Edelmetalloberfläche nachbildbar. Zinkat besitzt bei Temperaturen < 25°C und bei Temperaturen > 200°C einen spröden Charakter. Das heißt, während des Sinterns bei 250°C und während des Ruhezustands, d.h. während keiner Strombeaufschlagung, ist die Zinkat-Oberflächenschicht spröde. Im Temperaturbereich von > 75°C bis < 200°C, d.h. im normalen Betriebstemperaturbereich der Befestigung, ist die Zinkat-Oberflächenschicht duktil, so dass sie sich auf die mechanischen Spannungseigenschaften im System der erfindungsgemäßen Befestigung positiv auswirkt.

Weitere Einzelheiten, Merkmale und Vorteile ergeben sich aus der nachfolgenden Beschreibung eines in der Zeichnung schematisch und nicht maßstabgetreu gezeichneten Ausführungsbeispieles der erfindungsgemäßen Befestigung.

Es zeigen:
- Figur 1: eine abschnittweise Seitenansicht der erfindungsgemäßen Befestigung,
- Figur 2: einen Schnitt entlang der Schnittlinie II-II in Figur 1,
- Figur 3: einen Schnitt entlang der Schnittlinie III-III in Figur 2,
- Figur 4: eine der Figur 3 ähnliche abschnittweise Schnittdarstellung einer anderen Ausbildung der Befestigung, und
- Figur 5: eine den Figuren 3 und 4 ähnliche abschnittweise Schnittdarstellung noch einer anderen Ausführungsform der Befestigung.

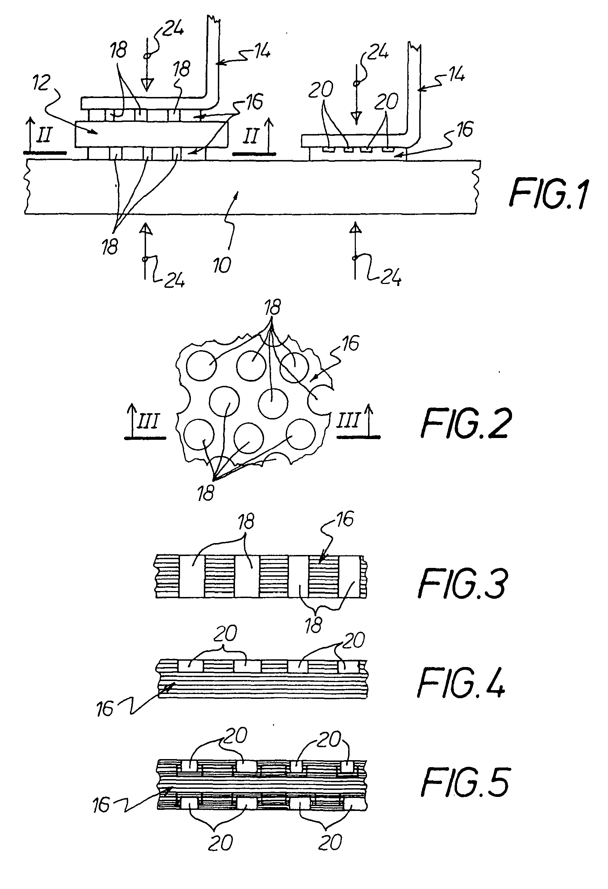

Figur 1 verdeutlicht abschnittweise ein Substrat 10, ein Bauelement 12, bei dem es sich um ein Chip-Bauelement handelt, und abschnittweise gezeichnete Anschlusselemente 14. Mit der Bezugsziffer 16 sind Sinter-Zwischenschichten bezeichnet, die zum Ausgleich der unterschiedlichen Wärmeausdehnungskoeffizienten des Substrates 10, des Bauelementes 12 und der Anschlusselemente 14 vorgesehen sind.

Die Sinter-Zwischenschichten 16 sind zum Ersatz an sich üblicher Molybdän-Metallkörper vorgesehen, sie sind nicht vollflächig sondern oberflächlich strukturiert ausgebildet. Die Figuren 2 und 3 verdeutlichen abschnittsweise eine Sinter-Zwischenschicht 16, die mit Durchgangslöchern 18 ausgebildet ist, um die Oberflächenstrukturierung der Sinter-Zwischenschicht 16 zu realisieren. Figur 3 verdeutlicht außerdem, dass die Sinter-Zwischenschicht 16 ein Mehrschichtgebilde ist, das durch Mehrfach-Maskenspritzen, Mehrfach-Maskensprühen, mehrfachen Sieb- oder Schablonendruck, durch Mehrfach-Stempeln oder dergleichen hergestellt ist.

Figur 4 verdeutlicht abschnittsweise stark vergrößert in einer Schnittdarstellung eine Ausbildung der Sinter-Zwischenschicht 16, die einseitig mit Sacklöchern 20 ausgebildet ist, welche die Oberflächenstrukturierung der Sinter-Zwischenschicht 16 bilden. Demgegenüber verdeutlicht die Figur 5 stark vergrößert, nicht maßstabgetreu abschnittweise in einer Schnittdarstellung eine Ausbildung der Sinter-Zwischenschicht 16 aus Kupfer oder Aluminium, die an ihren beiden sich gegenüber liegenden Seiten jeweils mit die Oberflächenstrukturierung bildenden Sacklöchern 20 ausgebildet ist.

Die Befestigung der Anschlusselemente 14 am Substrat 10 bzw. am Bauelement 12 und die Befestigung des Bauelementes 12 am Substrat 10 erfolgt mit Hilfe der Sinter-Zwischenschichten 16 durch Drucksintern. Das Drucksintern ist in Figur 1 durch die Pfeile 24 angedeutet. Beim Drucksintern wird in bekannter Weise auf die Fügepartner 10, 12, 14 ein geeigneter Druck bei einem bestimmten Temperatur ausgeübt. Zweckmäßig kann es hierbei sein, wenn der Fügepartner 10 und/oder der Fügepartner 12 und/oder der Fügepartner 14 eine Zinkat-Oberflächenschicht aufweist.

### Bezugsziffernliste:

- 10: Substrat
- 12: Bauelement (an 10)
- 14: Anschlusselement (an 12 bzw. 10)
- 16: Sinter-Zwischenschichten (zwischen 10, 12, 14)
- 18: Durchgangslöcher (in 16)
- 20: Sacklöcher (in 16)
- 24: Pfeile / Drucksinterung (von 12 an 10, 14 an 12, 14 an 10)

## Patentansprüche

1. Befestigung mindestens eines Bauelementes (12) an einem Substrat (10) und/oder eines Anschlusselementes (14) an dem Bauelement (12) und/oder an dem Substrat (10) durch Drucksintern, wobei zwischen dem Bauelement (12) und dem Substrat (10) und/oder dem Anschlusselement (14) und dem Bauelement (12) und/oder dem Anschlusselement (14) und dem Substrat (10) eine die unterschiedlichen Wärmeausdehnungskoeffizienten des Anschlusselementes (14), des Bauelementes (12) und des Substrates (10) ausgleichende Zwischenschicht (16) vorgesehen ist,
**dadurch gekennzeichnet,**
**dass** die Sinter-Zwischenschicht (16) aus Silber oder einer Silberlegierung besteht und nicht vollflächig sondern oberflächlich strukturiert ausgebildet ist, und eine Dicke von ≥ 50 µm aufweist.

2. Befestigung nach Anspruch 1,
**dadurch gekennzeichnet,**
**dass** die Sinter-Zwischenschicht (16) mit die Oberflächenstrukturierung bildenden Durchgangslöchern (18) ausgebildet ist.

3. Befestigung nach Anspruch 1,
**dadurch gekennzeichnet,**
**dass** die Sinter-Zwischenschicht (16) mindestens einseitig mit die Oberflächenstrukturierung bildenden Sacklöchern (20) ausgebildet ist.

4. Befestigung nach Anspruch 3,
**dadurch gekennzeichnet,**
**dass** die die Oberflächenstrukturierung bildenden Sacklöcher (20) an ihren beiden voneinander abgewandten Seiten jeweils mit die Oberflächenstrukturierung bildenden Sacklöchern (20) ausgebildet ist.

5. Befestigung nach einem der Ansprüche 1 bis 4,
**dadurch gekennzeichnet,**
**dass** die Sinter-Zwischenschicht (16) durch Maskenspritzen, Maskensprühen, Sieb- oder Schablonendruck oder durch Stempeln oberflächenstrukturiert ist.

6. Befestigung nach einem der Ansprüche 1 bis 5,
**dadurch gekennzeichnet,**
**dass** das Substrat (10) und/oder das Anschlusselement (14) und/oder das Bauelement (12) eine Zinkat-Oberflächenschicht aufweist.
